# EUROPEAN PATENT APPLICATION

(11) **EP 3 882 642 A1**
(43) Date of publication of application: **22.09.2021**
(21) Application number: 20163695.8
(22) Date of filing: 17.03.2020
(51) Int. Cl.: G01R 15/06, G01R 15/16

(54) **SENSORED INSULATION PLUG**

(71) Applicant: 3M Innovative Properties Company, Saint Paul, MN 55133-3427 (US)
(72) Inventor: Stollwerck, Dr. Gunther, 47802 Krefeld (DE); Gravermann, Mark, 41812 Erkelenz (DE)
(74) Representative: Müller, Bruno

(57) **Abstract**

Sensored insulation plug (1) for being inserted into a rear cavity of a medium-voltage or high-voltage separable connector. The sensored insulation plug is operable to insulate a connection element of the separable connector on elevated voltage and to sense the elevated voltage.

The sensored insulation plug has a plug body (140) formed by an insulating material and a primary capacitor (150), operable as a high-voltage capacitor in a voltage divider for sensing the elevated voltage.

The primary capacitor comprises
i) a high-voltage electrode (160) for direct electrical connection to the elevated voltage having a radially inner portion (220) and a radially outer portion (230) forming a generally toroidal trough (240) between the radially inner portion and the radially outer portion;
ii) a sensing electrode (170), embedded in the plug body (140), at least a portion of which is arranged in the trough (240);
iii) a dielectric formed by a portion (180) of the insulating material and arranged in the trough (240) between at least a portion of the sensing electrode (170) and at least a portion of the high-voltage electrode (160).

## Description

The present disclosure relates to voltage sensing devices for high-voltage and medium-voltage power networks, and especially to voltage sensing devices that can be connected to separable connectors used in such networks.

Power networks transmitting electrical power in large geographic areas, such as national grids, are becoming more complex to operate because nowadays consumers can generate energy on their premises and feed it into these networks in a decentralized manner, at unpredictable times and in unpredictable amounts. Network operators place voltage sensing devices in electrical installations at key locations of their network, such as in switchgears or transformers to collect information about the current state of their power network.

In a power network, a power cable is typically connected to network apparatus, such as switchgears or transformers, by a separable connector, also often referred to as a removable power connector, mounted at the end of the cable. Such separable connectors have a front cavity to receive a protruding portion of a bushing of the apparatus, and a connection element on high or medium voltage. The connection element is in contact with the cable conductor and can be mechanically and electrically connected to the bushing a threaded stud, accessible through an opposed rear cavity of the separable connector. After installation, the rear cavity is filled with a so-called insulation plug, which insulates the connection element.

Elements of a voltage sensor for measuring the voltage of the connection element of a separable connector - and thereby the voltage of the power cable - can be integrated into the insulation plug, making it a "sensored insulation plug". A sensored insulation plug is described, for example, in the U.S. patent US 6,031,368.

In order to sense the voltage of the connection element with high accuracy, a capacitive voltage divider may be used, of which the dividing ratio is precisely known. The high-voltage portion of such a voltage divider is often a single capacitor of a large capacitance, the primary capacitor or the "high-voltage capacitor". Advantageously the primary capacitor, or the entire high-voltage portion, is accommodated in the sensored insulation plug, making use of the insulative properties of the insulation plug.

Components of the sensored insulation plug are on elevated voltage, while an outer surface of the insulation plug is on a considerably lower voltage, so that parasitic currents flow through the plug material, which can be described by "parasitic capacitances". In typical sensored insulation plugs for voltages of about 50 kV, these parasitic capacitances are typically between 1 and 10 pF (picofarad), and they vary with the temperature of the plug material. For precise voltage measurement, the capacitance of the primary capacitor - or generally of the high-voltage portion of the voltage divider - should be clearly greater than these 1-10 pF, so that the signal voltage is not influenced greatly by variations of the parasitic capacitances. A capacitance of the primary capacitor which is clearly larger than 10 pF is therefore desirable.

Also, the voltage divider is usually connected to a measurement device which senses the divided voltage and determines the elevated voltage of the connection element from the divided voltage. A higher capacity of the primary capacitor is desirable in order to reduce the influence of the input impedance of the measurement device and to thereby provide for a higher accuracy in sensing the elevated voltage.

It is also desirable that a sensored insulation plug have the same outer shape and size as a regular, traditional insulating plug. This requirement limits the available space: the primary capacitor must be accommodated in the sensored insulation plug and must be properly insulated by the body material of the plug.

There is thus a need for a sensored insulation plug of a size and shape of a non-sensored, traditional insulation plug that has, at moderate cost, a large-enough capacity of the primary capacitor, desirably of more than 10 pF.

The present disclosure attempts to address these needs. It provides, in a first aspect, a sensored insulation plug for being inserted into a rear cavity of a medium-voltage or high-voltage separable connector in a power distribution network of a national grid, the sensored insulation plug being operable to insulate a connection element of the separable connector on elevated voltage and to sense the elevated voltage, the sensored insulation plug having an outer shape generally symmetrical about an axis defining axial directions and radial directions, and comprising
a) a plug body formed by an insulating material, and
b) a primary capacitor, operable as a high-voltage capacitor in a voltage divider for sensing the elevated voltage,
   the primary capacitor having
   i) a high-voltage electrode for direct electrical connection to the elevated voltage and having a radially inner portion and a radially outer portion forming a generally toroidal trough between the radially inner portion and the radially outer portion;
   ii) a sensing electrode, embedded in the plug body, whereby at least a portion of the sensing electrode is arranged in the trough;
   iii) a dielectric formed by a portion of the insulating material and arranged in the trough between at least a portion of the sensing electrode and at least a portion of the high-voltage electrode.

The geometric shape of the high-voltage electrode with its radially inner and radially outer portions forming a generally toroidal trough between them, in combination with a portion of the sensing electrode being arranged in the trough creates a particularly large capacitor surface while minimizing the size of the primary capacitor in axial direction. The resulting primary capacitor fits into the sensored insulation plug of a standard size and - due to its high capacitance - reduces the influence of parasitic capacitances and thereby facilitates high-accuracy voltage sensing.

An insulation plug as referred to herein is a traditional insulation plug as commonly used with separable connectors in medium voltage (MV) or high voltage (HV) power networks. Such insulation plugs are inserted into the rear cavity formed by separable connectors to insulate the connection element in the center of the separable connector after connecting the connection element with a corresponding connection element of, for example, a bushing of a switchgear or of a transformer. Many such insulation plugs have plug bodies of a generally frustro-conical shape. Such plug bodies are typically made of an insulating resin in which a high-voltage electrode and a ground electrode are embedded. An example of an insulation plug is shown and described in the European patent application published as EP 0 691 721 A1.

In the context of the present disclosure a sensored insulation plug is an insulation plug comprising a component of a voltage sensor, such as, for example, a primary capacitor or a high-voltage portion of a voltage divider of a voltage sensor. The component, for example the primary capacitor, may be embedded (partially or completely) in a plug body of the sensored insulation plug. In particular, a sensored insulation plug may be an insulation plug comprising a high-voltage capacitor of a voltage-dividing voltage sensor for sensing an elevated voltage. A sensored insulation plug may alternatively - or in addition - comprise a partial discharge sensor and/or a sensor for receiving signals of a powerline communication system.

The present disclosure relates to voltage sensing devices for use in medium-voltage or high-voltage power distribution networks in which electrical power is distributed via HV/MV power cables, transformers, switchgears, substations etc. with currents of tens or hundreds of amperes and voltages of tens of kilovolts. The term "medium voltage" or "MV" as used herein refers to AC voltages in the range of 1 kV to 72 kV, whereas the term "high voltage" or "HV" refers to AC voltages of more than 72 kV. Medium voltage and high voltage are collectively referred to herein as "elevated voltage".

The voltage sensor described herein comprises a voltage divider, which in use is electrically connected between the connection element on elevated voltage and electrical ground, for sensing the elevated voltage of the connection element of the separable connector, and which comprises, in its high-voltage portion, the primary capacitor of a sensored insulation plug according to the present disclosure.

A separable connector, by some also referred to as a removable cable connector, is a component, known in the industry, mounted at an end of a MV/HV power cable to electrically and mechanically connect, in a separable manner, the end of the power cable to a bushing of a switchgear or of a transformer of a power distribution network, e.g. of a national grid. Many separable connectors are T-shaped or elbow-shaped. A separable connector as referred to herein usually has a front cavity to receive a portion of the bushing, and an opposed rear cavity facilitating access to a connection element, such as a cable lug, on elevated voltage inside the separable connector. The connection element is conductive and is electrically and mechanically connected to the power conductor of the power cable. When the separable connector is in use, the connection element is therefore on the elevated voltage of the power conductor of the cable. The connection element can be threadedly connected, by a conductive threaded stud, to a conductive element of the bushing, so that power can flow from the power cable through the connection element, the stud and the bushing into the switchgear or transformer.

The rear cavity can receive an insulation plug to insulate the connection element and fill the space of the rear cavity to reduce the risk of electrical discharges. Certain separable connectors are described in the European patent application EP 0 691 721 A1 mentioned above.

Many traditional separable connectors can be provided with a respective matching insulation plug in order to insulate the rear cavity of the separable connector. Such matching pairs of separable connector and insulation plug are commercially available at moderate cost. In many cases, the mechanical interface between a separable connector and an insulation plug is governed by de-facto standards. Many of such interfaces conform to an existing standard for bushings, some form a Type C interface as described in the German standards DIN EN 50180 for bushings and DIN EN 50181 for plug-in type bushings, others conform to ANSI/IEEE standard 386. Often, bodies of insulation plugs are slightly larger than the rear cavity, so that when the plug is urged into the rear cavity with some force, the surfaces of plug and cavity are in an intimate surface contact, thus reducing the risk of electrical discharges.

The body of a sensored insulation plug is shaped for mating with a rear cavity of a separable connector in the same way as the body of a non-sensored insulation plug. The body of the sensored insulation plug may, for example, have a frustro-conical shape for being inserted into a corresponding frustro-conical recess of corresponding shape (the rear cavity) at a rear side of the separable connector for mating the sensored insulation plug with the separable connector.

Examples of traditional separable connectors are the 3M™ 600 Amp T-Bodies 5815 Series from 3M Co., St. Paul, Minnesota, U.S.A., or the "(M) (P) 480 TB separable tee shape connector" of Nexans Network Solutions N.V., Erembodegem, Belgium.

A connection element of a separable connector is electrically connected to the conductor of the power cable terminated by the separable connector and is on elevated voltage when the cable is in use.

Some separable connectors comprise a connection element which is a cable lug, attached to the end of the central conductor of the power cable and protruding into a space between the front cavity and the rear cavity. The protruding portion of the connection element usually has an aperture or a thread for attachment to a stud which connects the connection element electrically and mechanically, e.g. with a conductor of a bushing.

The connection element serves to electrically and mechanically connect the power cable and the separable connector to a bushing. The high-voltage electrode of the primary capacitor of the sensored insulation plug as described herein is - when in use - electrically connected to the connection element, so that a voltage sensor comprising the primary capacitor in its high-voltage portion can sense the elevated voltage of the connection element and of the power cable conductor.

The connection element is electrically connected to the voltage divider such that the voltage divider is usable to sense the elevated voltage of the connection element. For that purpose, the connection element on elevated voltage is electrically connected to the high-voltage electrode of the primary capacitor in the sensored insulation plug which in turn is operable as a high-voltage capacitor in a voltage divider for sensing the elevated voltage.

Also, the high-voltage electrode of the primary capacitor is not only electrically, but also mechanically connected to the connection element. This mechanical connection is an electrically conductive connection. This mechanical connection may be a direct mechanical connection, i.e. a portion of the high-voltage electrode is connected to the connection element without any intermediate element.

Alternatively, this connection may be an indirect mechanical connection, i.e. a portion of the high-voltage electrode is connected to the connection element via an intermediate element, which is electrically conductive. The sensored insulation plug may thus further comprise an intermediate element which is operable to mechanically and electrically connect the high-voltage electrode with the connection element. Such an intermediate element may be, for example, a contact piece. Such a contact piece may be connectable to the connection element of the separable connector via a conductive threaded stud that is threadedly connected to the connection element on one side and that can, on the other side, be threadedly engaged with the connection element of the sensored insulation plug.

Hence in certain embodiments the sensored insulation plug further comprises a contact piece, operable to mechanically and electrically connect the high-voltage electrode with the connection element of the separable connector.

A contact piece of the sensored insulation plug according to the present disclosure may be the high-voltage-electrode, or it may comprise the high-voltage electrode. Where the contact piece comprises the high-voltage electrode, the contact piece may have an engagement portion to engage with an intermediate element connecting the contact piece electrically with the connection element of the separable connector, and an electrode portion forming the high-voltage electrode. The engagement portion and the electrode portion may be formed as a single piece, e.g. as a single piece of metal. Alternatively, they may be formed as separate elements.

The contact piece, or an engagement portion of the contact piece, may comprise a recess to connectingly engage a stud that is connected to the connection element of the separable connector. The contact piece, or an engagement portion of the contact piece, may comprise an internal or external thread to connectingly and threadedly engage a threaded stud that is connected to the connection element of the separable connector.

The outer shape of the sensored insulation plug according to the present disclosure is generally symmetrical about an axis. It may, for example, be rotationally symmetric about the axis. The axis may be an axis which is parallel to a design insertion direction, i.e. a direction in which the insulation plug is supposed to be inserted into a separable connector.

The axis defines axial directions, which are directions parallel to the axis, and radial directions, which are directions orthogonal to the axial directions.

The sensored insulation plug according to the present disclosure comprises a plug body formed by an electrically insulating material. The plug body generally determines the outer shape of the sensored insulation plug. It is desirable that the plug body is mechanically rigid, has a high dielectric strength, has little variation of its relative permittivity with changes in temperature over the operating temperature range, does not absorb water and does not age. The insulating material may be, for example, a hardened or cured epoxy resin or a hardened or cured mixture of an epoxy resin with other materials, such as fillers, or a hardened or cured polyurethane resin or a hardened or cured mixture of a polyurethane resin with other materials, such as fillers. Useful fillers are, for example, SiO₂ or Al₂O₃ or other electrically insulating inorganic materials. Alternatively, the insulating material may be or may comprise, for example, a ceramic material.

The plug body may have a generally rotationally symmetric outer shape. In order to be usable with many existing separable connectors the plug body may have a generally frustro-conical outer shape, such that it can fill a frustro-conical rear cavity of the separable connector without leaving too many or too large voids between the inner surface of the rear cavity and the outer surface of the plug body.

Advantageously the sensored insulation plug, and in particular the shape of the plug body of the sensored insulation plug, is adapted to conform to DIN EN 50180 or to DIN EN 50181, which are a German industry standards for bushings. For use in other geographies it may be more advantageous that the sensored insulation plug, and in particular the shape of the plug body of the sensored insulation plug, is adapted to conform to industry standard ANSI/IEEE 386. When referring to an industry standard herein, the latest version as in force on 28 February 2020 is meant, e.g. ANSI/IEEE standard 386-2016, published 14 October 2016, is deemed to be in force on 28 February 2020. Conformance to an industry standard, although not a requirement for sensored insulation plugs as described herein, may generally help obtain compatibility with a greater number of separable connectors.

Hence in certain embodiments the plug body is shaped such as to conform with the ANSI/IEEE standard 386 in its latest version as in force on 28 February 2020.

The primary capacitor of the sensored insulation plug according to the present disclosure is operable as a high-voltage capacitor in a voltage divider for sensing the elevated voltage. The voltage divider may be a capacitive voltage divider. In other words, both its high-voltage portion and its low-voltage portion consist of one or more capacitors, respectively, and are free of other impedance elements, such as resistors or inductances. In other embodiments the voltage divider is a mixed voltage divider, in which the high-voltage portion comprises, beyond the primary capacitor, also an inductance or a resistor, and/or in which the low-voltage portion comprises a capacitor, an inductance or a resistor.

The high-voltage portion of the voltage divider is the portion that is electrically arranged between a signal contact, at which a divided voltage can be picked up, and the elevated voltage which is to be sensed. The low-voltage portion of the voltage divider is the portion that is electrically arranged between that signal contact and electrical ground.

### (may be the only cap of the HV portion)

The primary capacitor may be the only impedance element of the high-voltage portion of the voltage divider. In other words, there may be no other capacitor(s) and no other impedance elements electrically arranged between the elevated voltage and the signal contact of the voltage divider.

Independent of the number of capacitors in the voltage divider, the primary capacitor may be the first impedance element in an electrical chain of impedance elements of the voltage divider. In this chain, the primary capacitor may be arranged electrically at the end of the chain and adapted to be electrically connected directly with the elevated voltage. The primary capacitor would thus be the impedance element of the voltage divider which "sees" the full elevated voltage on its input side.

The primary capacitor may be directly electrically connected to the elevated voltage of the connection element, that is, the primary capacitor is electrically connected to the connection element without any intermediate element. In particular, the high-voltage electrode of the primary capacitor may be directly electrically connected to the elevated voltage of the connection element. This direct electrical connection may be established through the contact piece, which is a mechanical element between the high-voltage electrode and the connection element of the separable connector.

The expressions "directly electrically connected" and "direct electrical connection" as used herein refer to a fully conductive electrical connection between two elements, e.g. via a wire or via a conductive path on a PCB or via a conductive element, without any intermediate electrical component such as a resistor, a capacitor or an inductor, being arranged electrically between the two elements.

Like all capacitors, the primary capacitor has two opposed electrodes (namely its high-voltage electrode and its sensing electrode) and a dielectric between the electrodes. The dielectric is formed by a portion of the plug body in that some of its insulating material is arranged between at least a portion of the sensing electrode and a portion of the high-voltage electrode.

The toroidal trough-shape of the high-voltage electrode and the arrangement of the sensing electrode between two opposed portions of the high-voltage electrode maximise the area of overlap between the electrodes and thereby maximise the capacitance of the primary capacitor.

In certain embodiments of the sensored insulation plug according to the present disclosure, the trough is completely filled with the insulating material.

For elevated voltages of about 50 kV, frequencies of about 50 Hz and target dividing ratios of about 5000, a suitable capacitance of the primary capacitor is in the order of 30 pF. When designing the primary capacitor, further factors like the permittivity of the dielectric material and the geometry of the electrodes must be taken into account, as is generally known.

The expression "embedded in the plug body" as used herein refers to being surrounded completely by portions of the plug body.

The high-voltage electrode of the primary capacitor may be embedded in the plug body. A portion of the high-voltage electrode, or the entire high-voltage electrode, may be in surface contact with the insulating material of the plug body.

The high-voltage electrode of the primary capacitor may be connected to, or formed with, other components, e.g. components for support or electrical or mechanical connection of the high-voltage electrode, to form a high-voltage electrode assembly. Within a high-voltage electrode assembly, the high-voltage electrode is the element that is arranged opposite to the sensing electrode and that determines, in combination with the sensing electrode, the capacitance of the primary capacitor.

An edge of the high-voltage electrode may protrude into the plug body. The electrical field between that edge and the sensing electrode or between that edge and a grounded portion of the sensored insulation plug is quite strong, and field lines are likely to concentrate at the edge, creating electrical stress at the edge and in the portion of the plug body close to the edge. The sharper the edge, the stronger the electrical stress. To reduce electrical stress, the edge may be a rounded edge or it may be provided with a rounded profile. The edge may, for example, be curled inward or outward. Hence in certain embodiments, an edge of the high-voltage electrode is curled radially inwards or radially outwards for electrical stress control at the edge.

The high-voltage electrode is suitable for direct electrical connection to the elevated voltage. Where the high-voltage electrode is comprised in a contact piece, the contact piece may have an engagement portion to engage with an intermediate element connecting the contact piece electrically with the connection element of the separable connector, and an electrode portion forming the high-voltage electrode.

In certain embodiments, the high-voltage electrode has a generally axially symmetric shape relative to a symmetry axis defining axial and radial directions.

The radially inner portion and a radially outer portion of the high-voltage electrode are electrically connected with each other and are thus on the same electrical potential. In use, both portions are on elevated voltage.

The high-voltage electrode has a radially inner portion and a radially outer portion forming a generally toroidal trough between the radially inner portion and the radially outer portion.

The radially inner portion and the radially outer portion of the high-voltage electrode may generally extend in axial directions. The radially inner portion and the radially outer portion may generally extend in axial directions parallel to each other. The radially inner portion may be generally arranged facing the radially outer portion. In certain preferred embodiments the radially inner portion and the radially outer portion are arranged facing each other and extend in axial directions, parallel to each other.

The radially inner portion and a radially outer portion may be mechanically connected with each other by a connecting portion of the high-voltage electrode, such that the connecting portion forms a bottom of the generally toroidal trough. The connecting portion may be electrically conductive and may electrically connect the radially inner portion and a radially outer portion with each other.

The trough is generally of toroidal shape. The toroidal trough extends generally for a full 360° perimeter around a central element of the high-voltage electrode. The toroidal trough may be formed from circular trough elements which, in combination, extend generally for a full 360° perimeter around a central element of the high-voltage electrode. Alternatively, the toroidal trough may be formed from straight trough elements which, in combination, extend generally for a full 360° perimeter around a central element of the high-voltage electrode.

Hence, in certain embodiments of the sensored insulation plug according to the present disclosure, the trough extends generally for a full 360° perimeter around a central portion of the high-voltage electrode.

The "depth" of the trough is determined by the length over which the radially inner portion and the radially outer portion extend in axial directions parallel to each other and such that they face each other. The deeper the trough, the more space is available in the trough for accommodating a larger portion of the sensing electrode in the trough. The larger the portion of the sensing electrode accommodated in the trough, the greater the capacitance of the primary capacitor. A deeper trough is therefore generally preferred where a larger capacitance is desired.

The "width" of the trough is determined by the radial distance between the radially inner portion and the radially outer portion of the high-voltage electrode. A greater width will generally result in a smaller capacitance of the high-voltage capacitor. A narrower trough is therefore generally preferred where a larger capacitance is desired. This will result in less radial distance between the radially inner/outer portions of the trough and the portion of the sensing electrode arranged in the trough. Where this width of the trough is chosen too small, there may thus be a greater risk of electrical discharge between the high-voltage electrode and the sensing electrode.

Where the toroidal trough extends generally for a full 360° perimeter around a central element of the high-voltage electrode, at a certain angle of the perimeter the trough has a certain cross section. The cross section is determined, inter alia, by the shape of the radially inner and of the radially outer portion, by their orientation relative to each other, and - if present - by the shape and orientation of the connecting portion. The cross section of the trough may be, for example, generally rectangular, generally square, generally triangular, or generally semicircular. The cross section of the trough may have, for example, the shape of a filled "U" or of a filled "V".

Hence, in certain embodiments the trough has a generally rectangular cross section, a generally square cross section, a generally semi-circular cross section, a generally triangular cross section, a cross section of the shape of a filled "U", or a cross section of the shape of a filled "V".

The sensing electrode of the primary capacitor may be connected to, or formed with, other components, e.g. components for support or electrical or mechanical connection of the sensing electrode, to form a sensing electrode assembly. Within a sensing electrode assembly, the sensing electrode is the element that is arranged opposite to the high-voltage electrode and that determines, in combination with the high-voltage electrode, the capacitance of the primary capacitor.

The sensing electrode of the primary capacitor is embedded in the plug body. A portion of the sensing electrode, or the entire sensing electrode, may be in surface contact with the insulating material of the plug body.

The sensing electrode may be electrically connected, or connectable, to a low-voltage capacitor, such that the primary capacitor and the low-voltage capacitor form a voltage divider for sensing the elevated voltage of a connection element of a separable connector.

The low-voltage capacitor may be comprised in the sensored insulation plug. It may, for example, be embedded in the plug body. Alternatively, the low-voltage capacitor may not be comprised in the sensored insulation plug, but it may be arranged external to the sensored insulation plug. It may be remote from the sensored insulation plug. The sensing electrode of the primary capacitor may be electrically connected, or connectable, to the low-voltage capacitor, e.g. by a wire.

Hence generally, in certain embodiments the sensored insulation plug according to the present disclosure comprises a low-voltage capacitor, embedded in the plug body and electrically connected with the sensing electrode, such that the primary capacitor and the low-voltage capacitor form a voltage divider for sensing the elevated voltage of the connection element.

The primary capacitor of the sensored insulation plug is operable as a high-voltage capacitor in a voltage divider for sensing the elevated voltage of the connection element. The primary capacitor alone is not operable as a voltage divider, but it must be electrically connected with one or more other impedance elements, e.g. one or more further capacitors. These one or more further capacitors and the primary capacitor may then form a voltage divider which can sense the elevated voltage. The one or more further capacitors may be embedded in the plug body.

In certain other embodiments the primary capacitor is electrically connected to one or more further capacitors such that the primary capacitor and the one or more further capacitors form a capacitive voltage divider for sensing the elevated voltage of the connection element.

Hence, in certain embodiments, the primary capacitor is electrically connected to one or more further capacitors such that the primary capacitor and the one or more further capacitors form a capacitive voltage divider for sensing the elevated voltage of the connection element.

The one or more further capacitors may be comprised in the sensored insulation plug, e.g. they may be embedded in the plug body. Alternatively, the one or more further capacitors may be arranged outside the sensored insulation plug and not be comprised in it.

A portion of the sensing electrode is arranged in the trough formed by an inner and an outer portion of the high-voltage electrode.

The sensing electrode may generally extend in axial directions. The sensing electrode may generally extend in axial directions parallel to the radially inner portion, and/or parallel to the radially outer portion of the high-voltage electrode. The sensing electrode may be generally arranged facing the radially outer portion and/or facing the radially inner portion. In certain preferred embodiments the sensing electrode extends in axial directions, parallel to, and facing, the radially inner portion and the radially outer portion of the high-voltage electrode.

In order to reduce the risk of electrical discharge between the sensing electrode and the high-voltage electrode it is generally advisable to keep the electrodes at a distance from each other, because smaller distances are more likely to allow for discharges. For the portion of the sensing electrode arranged in the trough, it may be advantageous to arrange it such that its distance, e.g. in radial directions, to the radially inner portion and to the radially outer portion of the high-voltage electrode is equal. Hence, in certain embodiments of the sensored insulation plug described herein, the portion of the sensing electrode arranged in the trough is arranged equidistantly between the radially inner portion and the radially outer portion of the high-voltage electrode.

In certain embodiments the sensing electrode is generally bell-shaped. In some of those embodiments the edge portion of the bell may be arranged in the trough. A bell shape may be advantageous for its smaller number of sharp bends in the sensing electrode, which may result in a lower concentration of field lines at those bends. Where the bell shape is rotationally symmetric about an axis, the bell shaped sensing electrode may be easier to manufacture than other shapes. Also the bell shape may provide a structurally more stable sensing electrode even with a thinner electrode.

An edge of the sensing electrode may protrude into the plug body. It may protrude into the trough. Similar to the high-voltage electrode, the electrical field between that edge and the high-voltage electrode may be quite strong, and field lines are likely to concentrate at the edge, creating electrical stress at the edge and in the portion of the plug body close to the edge. The sharper the edge, the stronger the electrical stress. To reduce electrical stress, the edge may be provided with a rounded profile, e.g. it may be curled inward or outward. Hence in certain embodiments, an edge of the sensing electrode is curled radially inwards or radially outwards for electrical stress control at the edge.

Curling of the edge of the sensing electrode is independent from the presence or absence of a curling of an edge of the high-voltage electrode. Hence in certain embodiments of the sensored insulation plug, an edge of the sensing electrode is curled radially inwards or radially outwards for electrical stress control at the edge of the sensing electrode, and an edge of the high-voltage electrode is curled radially inwards or radially outwards for electrical stress control at the edge of the high-voltage electrode.

For the primary capacitor to form a voltage divider in conjunction with one or more low-voltage capacitors or another type of impedance element, the sensing electrode must be connectable with the low-voltage capacitor or the impedance element. For connection with an external low-voltage capacitor (i.e. one that is not comprised in the sensored insulation plug and/or not embedded in the sensored insulation plug) the sensored insulation plug may comprise a conductive insert that is electrically connected, i.e. directly connected, on one side with the sensing electrode, and that on the other side is connectable with the external low-voltage capacitor, e.g. via a wire connected to the conductive insert. For ease of use, the insert should have an externally accessible portion, for example one to which a wire can easily be soldered.

Hence in certain embodiments the sensored insulation plug comprises a conductive insert, electrically connected to the sensing electrode and comprising an externally accessible portion facilitating electrical contact of the sensing electrode with an external element.

Where the sensored insulation plug is to be threadedly engaged with the connection element of the separable connector, the insulation plug may have to be turned about its axis for engagement. The conductive insert may be shaped suitably, e.g. hexagonally, octogonally, square, or rectangularly, for engagement by a wrench or another tool, so that torque applied by the tool on the insert turns the entire sensored insulation plug. Hence, in certain embodiments, the externally accessible portion of the conductive insert is polygonally shaped such that external torque can be applied to the sensored insulation plug via the conductive insert.

In certain of these embodiments in which the sensored insulation plug comprises a low-voltage capacitor as described above, the low-voltage capacitor is electrically connected in series between the sensing electrode and the conductive insert. The primary capacitor and the low-voltage capacitor form the voltage divider for sensing the elevated voltage. The ground connection of the voltage divider can then be done via the conductive insert. For that purpose, the conductive insert may comprise an externally accessible portion facilitating connection of the conductive insert to ground.

Hence, in certain embodiments, the sensored insulation plug according to the present disclosure further comprises a conductive insert, wherein the low-voltage capacitor is electrically connected in series between the sensing electrode and the conductive insert, and wherein the conductive insert comprises an externally accessible portion facilitating connection of the conductive insert to ground.

Also in the embodiments in which the conductive insert is on electrical ground, the insulation plug may have to be turned about its axis for engagement. The conductive insert may be shaped suitably, e.g. hexagonally, octogonally, square, or rectangularly, for engagement by a wrench or another tool, so that torque applied by the tool on the insert turns the entire sensored insulation plug. Hence, in certain embodiments, the externally accessible portion of the conductive insert is polygonally shaped such that external torque can be applied to the sensored insulation plug via the conductive insert.

Different from embodiments described elsewhere herein, in the embodiments described in the last three paragraphs the conductive insert is on ground, and a further contact, an output contact, is required for picking up the signal voltage (which is the voltage of the sensing electrode, i.e. the divided voltage of the voltage divider which varies proportionally with the elevated voltage) from outside the sensored insulation plug. Advantageously this output contact is arranged on the outer surface of the sensored insulation plug to facilitate connection of a wire or to facilitate establishing a surface contact.

Hence generally, in certain embodiments, the sensored insulation plug further comprises an output contact on the outer surface of the sensored insulation plug, electrically connected to the sensing electrode, for making the voltage of the sensing electrode available outside the sensored insulation plug.

The electrodes of the primary capacitor are the high-voltage electrode and the sensing electrode. Like all capacitors, the primary capacitor comprises a dielectric arranged between its electrodes.

According to the present disclosure a dielectric of the primary capacitor is formed by a portion of the insulating material of the plug body. The plug body is made of an electrically insulating, i.e. a dielectric, material anyway in order for the sensored insulation plug to fulfil its task of insulating the connection element of the separable connector. Using the same material to form the dielectric avoids the use of a second material for the dielectric, and thereby avoids interfaces between the plug body material and the dielectric, making the sensored insulation plug more reliable and more cost-effective to manufacture.

Generally, a dielectric between the electrodes increases the capacitance of the primary capacitor, compared to air as the dielectric, and makes the capacitor suitable for use with high and medium voltages. According to the present disclosure the dielectric is arranged in the trough formed by the high-voltage electrode. More specifically it is arranged between at least a portion of the sensing electrode and at least a portion of the high-voltage electrode. In certain embodiments it is arranged between the sensing electrode and the high-voltage electrode. In certain embodiments it is arranged between a portion of the sensing electrode and the high-voltage electrode. In certain embodiments it is arranged between the sensing electrode and a portion of the high-voltage electrode. The arrangement of the dielectric in this place may help increase the capacitance of the primary capacitor further.

The electrodes of the primary capacitor are on significantly different voltages, so that a strong electric field exists between them. Air-filled voids in the dielectric would increase the risk of partial discharges through these voids. Advantageously the dielectric is therefore a continuous material, i.e. free of voids.

Advantageously the toroidal trough formed by the high-voltage electrode is filled completely with the dielectric or with the insulating material of the plug body. This may help in increasing the capacitance of the primary capacitor.

The dielectric may be, for example, a hardened epoxy resin, or it may comprise, for example, a hardened epoxy resin. The dielectric may be, for example, a hardened polyurethane resin, or it may comprise, for example, a hardened polyurethane resin. The insulating material may be, for example, a hardened or cured mixture of an epoxy resin or of a polyurethane resin with other materials, such as fillers. Useful fillers are, for example, SiO₂ or Al₂O₃ or other electrically insulating inorganic materials. Alternatively, the insulating material may be or may comprise, for example, a ceramic material. Generally, the material of the dielectric is the insulating material forming the plug body. The insulating material may be a mixture of component materials. It may be homogenous or inhomogenous.

The dielectric should have a relative permittivity εᵣ of at least about 2 to provide an adequate capacitance to the primary capacitor and to reduce the risk of discharges between the electrodes. Preferably, the dielectric has a relative permittivity of between 2 and 8, more preferably of between 4 and 6. Such dielectric materials are available at reasonable cost and provide for an adequate capacitance of the primary capacitor.

The sensored insulation plug according to the present disclosure is for insertion into a separable connector and for sensing the elevated voltage of the separable connector. The present disclosure therefore, in a second aspect, provides a separable connector comprising a connection element for conducting power on elevated voltage, a rear cavity and a sensored insulation plug as described herein, inserted into the rear cavity, wherein the high-voltage electrode is electrically connected with the connection element.

In a further aspect the present disclosure provides a power distribution network of a national grid, comprising a high-voltage or medium-voltage power cable and a separable connector as described in the previous paragraph, installed on an end of the power cable.

The sensored insulation plug according to the present disclosure will now be described in more detail with reference to the following Figures exemplifying particular embodiments, in which like numbers refer to like elements:
- Fig. 1: Sectional view of a separable connector and a first sensored insulation plug according to the present disclosure;
- Fig. 2: Sectional view of the first sensored insulation plug;
- Fig. 3: Sectional view of a second sensored insulation plug according to the present disclosure; and
- Fig. 4: Circuit diagram of a voltage divider in which a sensored insulation plug according to the present disclosure can be used.

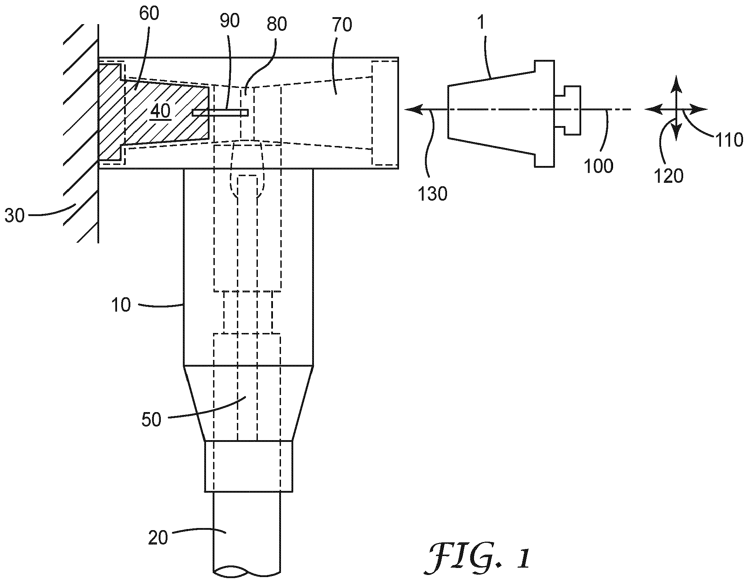

The sectional view of **Figure 1** illustrates a separable connector 10 and a first sensored insulation plug 1 according to the present disclosure. The separable connector 10 is arranged at an end of a medium-voltage power cable 20 and connects, via a bushing 40, the power-carrying central conductor 50 of the cable 20 to a MV switchgear 30 in a power distribution network of a national grid.

The separable connector 10 is a T-shaped separable connector 10 and comprises a front cavity 60 for receiving the bushing 40, and a rear cavity 70 for receiving an insulation plug of a matching shape. The insulation plug may be a traditional insulation plug without a sensor or a sensored insulation plug 1 according to the present disclosure, shown in Figure 1 to the right of the rear cavity 70, before being inserted into the rear cavity 70. A traditional insulation plug and a sensored insulation plug 1 according to the present disclosure both serve to electrically insulate a connection element 80 of the separable connector 10, which is electrically connected to the central conductor 50 of the cable 20 and can be electrically and mechanically connected to a conductive component of the bushing 40 via a threaded stud 90. In use, the connection element 80 is on the elevated voltage of the central conductor 50 of the cable.

A sensored insulation plug 1 according to the present disclosure, just like a traditional insulation plug, has an overall frustro-conical outer shape generally rotationally symmetric about an axis 100 which defines axial directions 110 and radial directions 120, which are directions orthogonal to the axial directions 110. The sensored insulation plug 1 can be inserted into the rear cavity 70 by moving it axially in an axial insertion direction 130 into the rear cavity 70 where it can be threadedly engaged - and thereby electrically connected - with the connection element 80 on elevated voltage. The geometry of the sensored insulation plug 1 is adapted to conform to ANSI/IEEE standard 386. Conformance to an industry standard, although not a requirement for insulation plugs, may generally help obtain compatibility with a greater number of separable connectors.

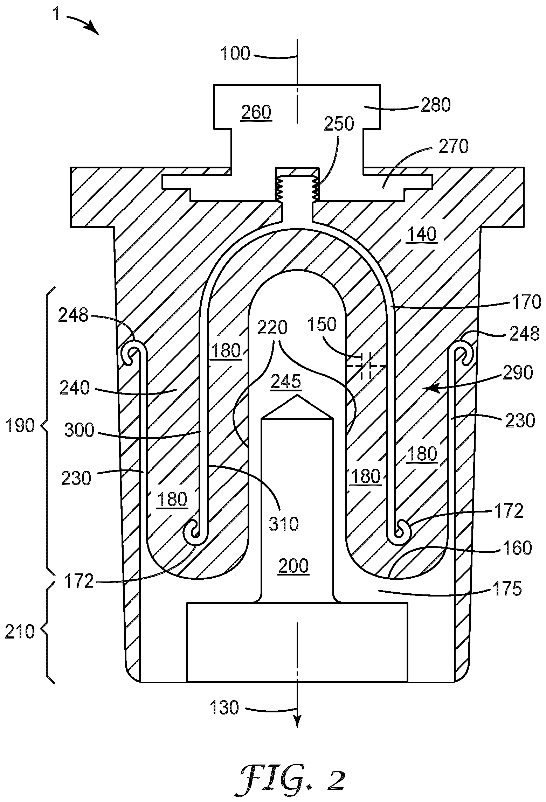

In addition to a traditional, non-sensored insulation plug, the sensored insulation plug 1 comprises a primary capacitor, which can be electrically connected to the connection element 80 on elevated voltage and which is operable as a high-voltage capacitor in a voltage divider for sensing the elevated voltage, as will be explained in the context of Figure 2.

**Figure 2** is a sectional view of the first sensored insulation plug 1 of Figure 1. It comprises a plug body 140 of an electrically insulating hardened resin and a primary capacitor 150, formed by a high-voltage electrode 160 and a sensing electrode 170, with its dielectric being formed by a portion 180 of the insulating material of the plug body 140.

The high-voltage electrode 160 is comprised in an electrode portion 190 of a contact piece 175 of conductive metal. The contact piece 175 has, further to the electrode portion 190, an engagement portion 210 for mechanical engagement with an intermediate element connecting the contact piece 175 electrically with the connection element 80 of the separable connector 10. The electrode portion 190 forms the high-voltage electrode 160. The engagement portion 210 and the electrode portion 190 are formed as a single piece of metal.

The contact piece 175 comprises a threaded recess 200 to connectingly engage a stud for mechanical and direct ohmic electrical connection to the connection element 80 of the separable connector 10. In use, the contact piece 175 and its electrode portion 190 are on the elevated voltage of the connection element 80 of the separable connector 10.

The high-voltage electrode 160 is rotationally symmetric about the axis 100, and it has a radially inner portion 220 and a radially outer portion 230 forming a trough 240 between them. The trough 240 is of a generally toroidal shape, due to the rotational symmetry of the sensored insulation plug 1 about the axis 100. The trough 240 is completely filled with the insulating material of the plug body 140. The trough 240 extends generally for a full 360° perimeter around a central portion 245 of the high-voltage electrode 160.

The distal edge 248 of the high-voltage electrode 160 is curled radially outwards for electrical stress control at the edge 248.

The sensing electrode 170 is generally of a bell shape in the depicted embodiment and comprises a threaded support prong 250 which connects the sensing electrode 170 mechanically and electrically with a conductive insert 260. The insert 260 has an embedded portion 270, embedded in the plug body 140, and a protruding portion 280, protruding from the plug body 140 and therefore externally accessible. The protruding portion 280 of the insert 260 has a hexagonal shape, so that the torque of a wrench can be transmitted into the entire sensored insulation plug 1, which can thereby be threadedly engaged, via a stud (not shown), with the connection element 80 of the separable connector 10. The distal edge 172 of the sensing electrode 170 is curled radially outwards for electrical stress control at the edge 172.

In the embodiment shown in Figure 2, the voltage of the sensing electrode 170 can be picked up at the conductive insert 260, and via the insert 260 the primary capacitor 150 can be electrically connected to a low-voltage capacitor, e.g. by a wire, such that the primary capacitor 150 and the low-voltage capacitor form a capacitive voltage divider for sensing the elevated voltage of the connection element 80 of the separable connector 10 into which the sensored insulation plug 1 is inserted.

A portion of the sensing electrode 170 distal from the support prong 250, namely its lower portion 290 as illustrated in Figure 2, is arranged in the trough 240, and is embedded in the portion 180 of the insulating material of the plug body 140 located in the trough 240. This arrangement in the trough 240 provides that a radially outer surface portion 300 of the sensing electrode 170 faces the radially outer portion 230 of the high-voltage electrode 160, and a radially inner surface portion 310 of the sensing electrode 170 faces the radially inner portion 220 of the high-voltage electrode 160. This double-facing arrangement increases the overall capacitance of the primary capacitor 150 considerably. The overall capacitance of the primary capacitor 150 illustrated in Figure 2 is about 35 pF, while other capacitor geometries were measured to provide capacitances of up to 25 pF only.

The higher capacitance of the primary capacitor 150 reduces the impact of certain unavoidable parasitic capacitances and thereby allows for a higher accuracy in the sensing of the elevated voltage of the separable connector 10.

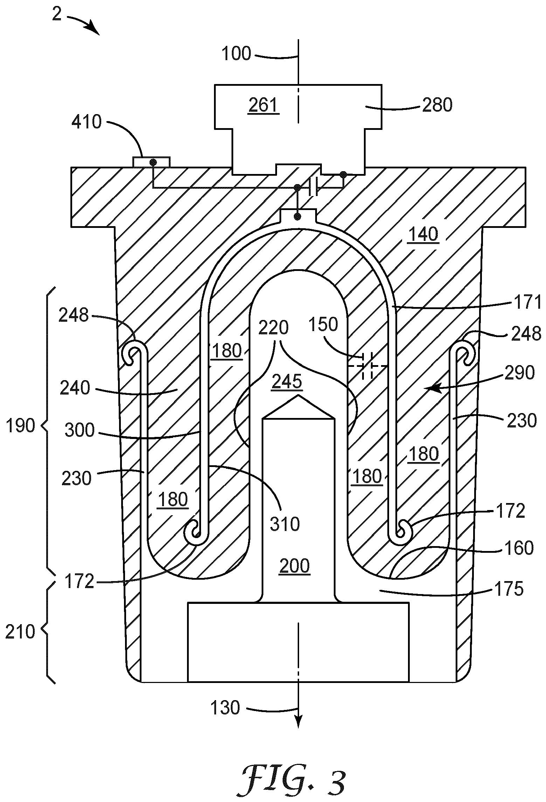

**Figure 3** illustrates an alternative embodiment of a sensored insulation plug according to the present disclosure in a sectional view, combined with elements of circuit diagrams. This second sensored insulation plug 2 is identical to the first sensored insulation plug 1 of Figures 1 and 2, except that the sensing electrode 171 is not directly electrically connected with the conductive insert 261, and that the voltage of the sensing electrode 171 is led to an output contact 410, while the conductive insert 261 is held on electrical ground.

In the embodiment of Figure 3 the sensing electrode 171 is electrically connected to a low-voltage capacitor 320 of the voltage divider 400. Physically, the low-voltage capacitor 320 is embedded in the plug body 140 and is arranged on a circuit board (not shown) which is also embedded in the plug body 140. In this second sensored insulation plug 2 the conductive insert 261 is on electrical ground 350, and a separate output contact 410 is arranged on the outer surface of the sensored insulation plug 2, externally accessible for contacting it e.g. by soldering a wire to it or by establishing a surface contact with it. The output contact 410 is electrically connected to the sensing electrode 171 and thereby makes the signal voltage, i.e. the voltage of the sensing electrode 171, available outside the sensored insulation plug 2, such as for sensing the voltage of the sensing electrode 171 (the divided voltage) by a measurement device such as a voltmeter 390. In the embodiment shown in Figure 3 the low-voltage capacitor 320 is electrically connected in series between the sensing electrode 171 and the conductive insert 261 on electrical ground 350. The externally accessible portion 280 of the conductive insert 261 facilitates connection of the conductive insert 261 to ground.

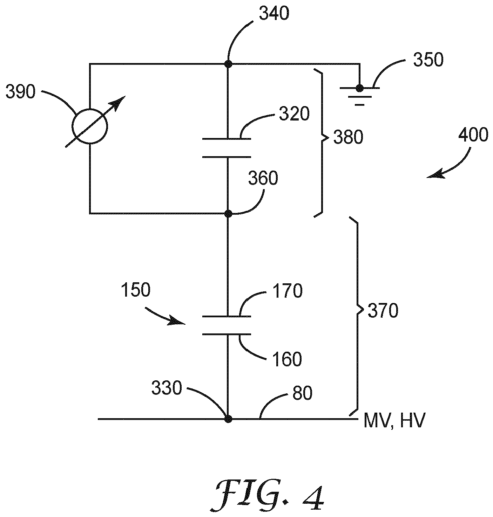

**Figure 4** is a circuit diagram of a voltage divider 400 for sensing the elevated voltage of the separable connector 10 in which the sensored insulation plugs 1, 2 of the present disclosure can be used.

The voltage divider 400 for sensing the elevated voltage of the separable connector 10 is shown electrically connected to a connection element 80 of the separable connector 10 on medium or high (i.e. elevated) voltage. The voltage divider 400 comprises a high-voltage capacitor 150, corresponding to the primary capacitor 150 in the sensored insulation plugs 1, 2 described above, and a low-voltage capacitor 320. These two capacitors are electrically connected in series between a high-voltage contact 330 and a low-voltage contact 340, held on electrical ground 350.

The high-voltage contact 330 facilitates connection to the connection element 80 on elevated voltage. The contact piece 175 of the sensored insulation plugs 1, 2 described herein may be, or may comprise, the high-voltage contact 330. The low-voltage contact 340 facilitates connection of the voltage divider 400 to electrical ground 350. In the second sensored insulation plug 2 described above, the low-voltage contact 340 corresponds to the conductive insert 261 on electrical ground 350.

A signal contact 360 is arranged electrically between a high-voltage portion 370 and a low-voltage portion 380 of the voltage divider 400. At the signal contact 360, a divided voltage, also referred to herein as the signal voltage, can be picked up, which varies proportionally with the elevated voltage of the connection element 80. The proportionality factor between the elevated voltage and the signal voltage depends on the ratio of the total impedance of the high-voltage portion 370 to the total impedance of the low-voltage portion 380 of the voltage divider 400. By measuring the signal voltage of the signal contact 360 using a voltmeter 390, the elevated voltage of the connection element 80 can be sensed.

In the illustrated embodiment, the high-voltage portion 370 comprises only one capacitor, namely the primary capacitor 150, with its high-voltage electrode 160 and its sensing electrode 171. In other embodiments the high-voltage portion 370 may comprise, beyond the primary capacitor 150, one or more further capacitors. It may comprise, beyond the primary capacitor 150, one or more further impedance elements, such as one or more resistors and/or one or more inductors.

Similarly, in the illustrated embodiment, the low-voltage portion 380 comprises only one capacitor, namely the low-voltage capacitor 320. In other embodiments the low-voltage portion 380 may comprise, beyond the low-voltage capacitor 320, one or more further capacitors. It may comprise, beyond the low-voltage capacitor 320, one or more further impedance elements, such as one or more resistors and/or one or more inductors.

## Claims

1. Sensored insulation plug (1, 2)
for being inserted into a rear cavity (70) of a medium-voltage or high-voltage separable connector (10) in a power distribution network of a national grid, the sensored insulation plug being operable to insulate a connection element (80) of the separable connector on elevated voltage and to sense the elevated voltage,
the sensored insulation plug having an outer shape generally symmetrical about an axis (100) defining axial directions (110) and radial directions (120), and comprising
a) a plug body (140) formed by an insulating material, and
b) a primary capacitor (150), operable as a high-voltage capacitor in a voltage divider (400) for sensing the elevated voltage,
the primary capacitor having
i) a high-voltage electrode (160) for direct electrical connection to the elevated voltage and having a radially inner portion (220) and a radially outer portion (230) forming a generally toroidal trough (240) between the radially inner portion and the radially outer portion;
ii) a sensing electrode (170, 171), embedded in the plug body (140), whereby at least a portion of the sensing electrode is arranged in the trough (240);
iii) a dielectric formed by a portion (180) of the insulating material and arranged in the trough (240) between at least a portion of the sensing electrode (170, 171) and at least a portion of the high-voltage electrode (160).

2. Sensored insulation plug (1) according to any one of the preceding claims, wherein the trough (240) extends generally for a full 360° perimeter around a central portion (245) of the high-voltage electrode (160).

3. Sensored insulation plug (1, 2) according to any one of the preceding claims, wherein the trough (240) has a generally rectangular cross section, a generally square cross section, a generally semi-circular cross section, a generally triangular cross section, a cross section of the shape of a filled "U", or a cross section of the shape of a filled "V".

4. Sensored insulation plug (1, 2) according to any one of the preceding claims, wherein an edge (248) of the high-voltage electrode (160) is curled radially inwards or radially outwards for electrical stress control at the edge.

5. Sensored insulation plug (1, 2) according to any one of the preceding claims, wherein the sensing electrode (170, 171) is generally bell-shaped.

6. Sensored insulation plug (1, 2) according to any one of the preceding claims, wherein an edge (172) of the sensing electrode (170, 171) is curled radially inwards or radially outwards for electrical stress control at the edge.

7. Sensored insulation plug (1, 2) according to any one of the preceding claims, wherein the portion of the sensing electrode (170, 171) arranged in the trough (240) is arranged equidistantly between the radially inner portion (220) and the radially outer portion (230) of the high-voltage electrode (160).

8. Sensored insulation plug (1, 2) according to any one of the preceding claims, further comprising a conductive insert (260, 261), electrically connected to the sensing electrode (170, 171) and comprising an externally accessible portion (280) facilitating electrical contact of the sensing electrode with an external element.

9. Sensored insulation plug (1, 2) according to claim 8, wherein the externally accessible portion (280) is polygonally shaped such that external torque can be applied to the sensored insulation plug via the conductive insert (260, 261).

10. Sensored insulation plug (2) according to any one of claims 1 to 7, further comprising a low-voltage capacitor (320), embedded in the plug body (140) and electrically connected with the sensing electrode (171), such that the primary capacitor (150) and the low-voltage capacitor (320) form a voltage divider (400) for sensing the elevated voltage of the connection element (80).

11. Sensored insulation plug (2) according to claim 10, further comprising a conductive insert (261), wherein the low-voltage capacitor (320) is electrically connected in series between the sensing electrode (171) and the conductive insert (261), and wherein the conductive insert (261) comprises an externally accessible portion (280) facilitating connection of the conductive insert (261) to ground (350).

12. Sensored insulation plug (2) according to claim 10 or claim 11, further comprising an output contact (410) on the outer surface of the sensored insulation plug (2), electrically connected to the sensing electrode (171), for making the voltage of the sensing electrode (171) available outside the sensored insulation plug (2).

13. Sensored insulation plug (1) according to any one of the preceding claims, wherein the plug body (140) is shaped such as to conform with the ANSI/IEEE standard 386 in its latest version as in force on 28 February 2020.

14. Separable connector (10) comprising a connection element (80) for conducting power on elevated voltage, a rear cavity (70) and a sensored insulation plug (1) according to any one of the preceding claims, inserted into the rear cavity (70), wherein the high-voltage electrode (160) is electrically connected with the connection element.

15. Power distribution network of a national grid, comprising a high-voltage or medium-voltage power cable (20) and a separable connector (10) according to claim 14, installed on an end of the power cable.
